Europäisches Patentamt

European Patent Office

Office européen des brevets

(11) Veröffentlichungsnummer: **0 182 184**
**B1**

(12) **EUROPÄISCHE PATENTSCHRIFT**

(45) Veröffentlichungstag der Patentschrift: 17.10.90

(51) Int. Cl.⁵: **H 01 L 21/60**

(21) Anmeldenummer: 85114001.2

(22) Anmeldetag: 04.11.85

(54) **Verfahren zum blasenfreien Verbinden eines grossflächigen Halbleiter-Bauelements mit einem als Substrat dienenden Bauteil mittels Löten.**

(30) Priorität: 22.11.84 DE 3442537

(43) Veröffentlichungstag der Anmeldung:
28.05.86 Patentblatt 86/22

(45) Bekanntmachung des Hinweises auf die
Patenterteilung:
17.10.90 Patentblatt 90/42

(84) Benannte Vertragsstaaten:
CH DE FR GB LI SE

(56) Entgegenhaltungen:
US-A-2 694 852
US-A-3 153 581
US-A-3 860 949
US-A-4 409 278

IBM TECHNICAL DISCLOSURE BULLETIN, Band
2, Nr. 6, April 1960, Seite 69, New York, US; W.E.
DUNKEL: "Diode heat sink"

(73) Patentinhaber: BBC Brown Boveri AG
Haselstrasse
CH-5401 Baden (CH)

(72) Erfinder: Keser, Helmut
Hinterhof 382
CH-5242 Birr (CH)

Courier Press, Leamington Spa, England.

**Beschreibung**

Die Erfindung geht aus von einem Verfahren zum blasenfreien Verbinden eines Halbleiter-Bauelements mit einem als Substrat dienenden Bauteil nach der Gattung des Oberbegriffs des Anspruchs 1.

In der Technologie der Leistungselektronik müssen die Halbleiter-Bauelemente, welche beträchtliche Querschnittsflächen aufweisen können, mit einem der Stromzuleitung dienenden Substrat kontaktiert, d.h. stromschlüssig verbunden werden.

Dies kann auf verschiedene Weise bewerkstelligt werden:

a) Kleben mit Ein- oder Zweikomponenten-Leitkleber auf Epoxydharzbasis.

b) Verbinden des Bauelements mit dem Substrat, indem letzteres mit flüssigem Lot überzogen und ersteres auf das Lot schwimmend aufgesetzt wird.

c) Löten mit Gold unter Druck im Vakuum.

d) Reiner mechanischer Druckkontakt: Die mit ebenen metallischen Flächen versehenen Bauteile werden unter Druck zusammengepresst in ein Gehäuse eingebaut.

Die herkömmlichen Technologien führen insbesondere bei grossflächigen Bauelementen zu folgenden, zum Teil nicht befriedigenden Ergebnissen und Unzulänglichkeiten:

a) Schlechte Wärmeableitung und unregelmässige Stromverteilung zufolge von Gaseinschlüssen.

b) Nicht kontrollierbare Dicke der Lotschicht und unregelmässige Beschichtung durch Oxyde und Staubpartikel.

c) Hohe Materialkosten und Gefahr der Lunkerbildung.

d) Hohe Materialkosten, teure und aufwendige Konstruktion.

Beim Lötverfahren ähnlich b) können die Verunreinigungen durch Auflegen von Gewichten unter Benutzung von Lötlehren zwar nach aussen gequetscht werden, doch bleibt der Lötspalt weitgehend nicht definiert und es treten Keilfehler auf.

Die verschiedenen Löttechniken sind unter anderem aus den nachfolgenden Veröffentlichungen bekannt:

H. Parthey, "Grenzschichtprobleme beim Löten", Mitteilungen Forschungsgesellschaft Blechverarbeitung, 1965, Nr. 23/24, Seiten 365-367.

W. Leibfried, "Löten von Chip-Bauelementen", DVS-Berichte, Band 82, München 1983.

- H. J. Hartmann, "Entwicklung zuverlässiger Kontaktierungsverfahren mit Weichloten für elektronische Schaltkreise einschliesslich Untersuchung der Grenzflächenreaktionen beim Weichlöten", Forschungsbericht BMFT-FB — 164, Dezember 1979.

Es ist weiterhin aus der Druckschrift IBM Technical Disclosure Bulletin, Vol. 2, No. 6, April 1960 "Diode Heat Sink", W. E. Dunkel, Seite 69, bekannt, eine Siliziumdiode direkt auf einen Kupferbolzen zu löten. Eine schwierig herzustellende Zwischenschicht, die aus einem mit Lot gefüllten Kupfergewebe besteht, wird dabei auf das Silizummaterial und auf den Kupferbolzen gelötet.

Aus der US-A-2 694 852 ist ein Lötverfahren bekannt, bei dem zwei metallische Körper durch Löten verbunden werden. Ein abgeflachtes Metallgewebe (12) wird vor dem Löten zwischen zwei Silber-Lötfolien (17) angeordnet. Die zu verbindenden Teile werden derart aufeinandergepresst, dass sich das Lötmaterial im Metallgewebe verteilt und dieses ausfüllt. Die Verunreinigungen werden hierbei jedoch nicht nach aussen gequetscht, sondern verbleiben in den Lücken.

Schliesslich ist aus der US-A-3 860 949 ein Lötverfahren bekannt, bei dem ein Halbleiter-Bauelement mit einem als Substrat dienenden Bauteil blasenfrei verbunden wird. Hierbei wird jedoch keine metallische Zwischenlage verwendet, sondern das Substrat selbst auf umständliche Weise mit Kanälen für den Gastransport versehen und zusätzlich mit einer die Benetzung fördernden Ni-Schicht überzogen.

Aus dem Dargelegten geht hervor, dass ein Bedürfnis besteht, die herkömmlichen Verbindungstechnologien zu verbessern und zuverlässiger zu gestalten.

Der Erfindung liegt also die Aufgabe zugrunde, ein Lötverfahren zum blasen- und porenfreien Verbinden eines grossflächigen, ebenen Halbleiter-Bauelements mit einem metallischen Substrat anzugeben, das gute elektrische Leitfähigkeit und gleichmässige Stromverteilung gewährleistet und einfach durchzuführen ist.

Diese Aufgabe wird bei einem Verfahren der eingangs genannten Art durch die im kennzeichnenden Teil des Anspruchs 1 angegebenen Merkmale gelöst.

Die Erfindung wird anhand des nachfolgenden, durch Figuren näher erläuterten Ausführungsbeispiels beschrieben. Dabei zeigt:

Fig. 1 einen allgemeinen schematischen Schnitt (Aufriss) durch die zu verbindenden Bauteile vor dem Löten;

Fig. 2 einen allgemeinen schematischen Schnitt (Aufriss) durch die verbundenen Bauteile nach dem Löten;

Fig. 3 einen Grundriss einer als strukturierte Folie ausgebildeten Zwischenlage;

Fig. 4 einen Grundriss der Bauteile nach dem Löten unter Verwendung einer strukturierten Folie als Zwischenlage;

Fig. 5 ein Metallgewebe als Zwischenlage in Aufriss/Schnitt und Grundriss;

Fig. 6 einen Schnitt (Aufriss) durch die zu verbindenden Bauteile vor dem Löten unter Verwendung eines Metallgewebes als Zwischenlage,

Fig. 7 einen Schnitt (Aufriss) durch die verbundenen Bauteile nach dem Löten unter Verwendung eines Metallgewebes als Zwischenlage.

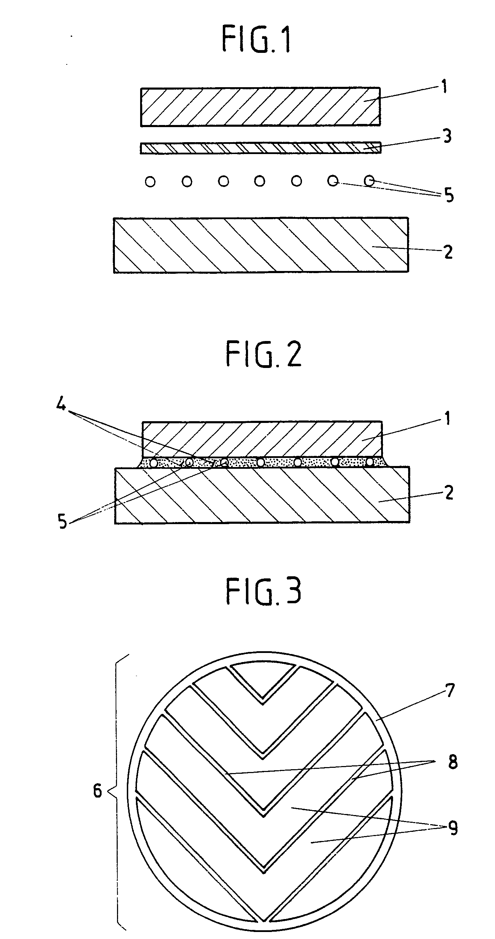

In Fig. 1 ist ein Schnitt (Aufriss) der zu verbindenden Bauteile vor dem Löten allgemein schematisch dargestellt. 1 ist ein grossflächiges ebenes Halbleiter-Bauelement, meist kreisförmigen Querschnitts. Seine Dicke ist im Vergleich zum Durchmesser stark übertrieben dargestellt. 2 ist das im Durchmesser gegenüber dem Halbleiter-Bauelement etwas grössere, als Substrat 2 dienende Bauteil aus Kupfer, einer Kupferlegierung oder sonst einem geeigneten metallischen Werkstoff hoher elektrischer Leitfähigkeit. 3 ist das als Folie ausgebildete Lot vor dem Löten. Mit dem Bezugszeichen 5 ist die durchbrochene metallische Zwischenlage allgemein schematisch bezeichnet.

In Fig. 2 sind die in Fig. 1 bezeichenten Bauteile nach dem Löten im Schnitt (Aufriss) allgemein schematisch dargestellt. 4 ist das den Zwischenraum zwischen dem Halbleiter-Bauelement 1, dem Substrat 2 und der Zwischenlage 5 ausfüllende Lot nach dem Löten.

Fig. 3 zeigt einen Grundriss einer als strukturierte Folie 6 ausgebildeten Zwischenlage. Die kreisförmige Folie 6 weist am äusseren Umfang einen Stützring 7 auf. Der grösste Teil ihrer Fläche ist durch Herausstanzen oder Herausätzen entfernt, so dass, in einer auf der Lötebene senkrecht stehenden Betrachtungsrichtung gesehen, V-förmige, bis zum Stützring 7 am Umfang verlaufende, als Kanäle zur Entgasung der Lötspalten dienende Durchbrüche 9 gebildet werden. Die stehengebliebenen, als Abstandhalter dienenden, vergleichsweise schmalen Stege 8 haben vorzugsweise eine Breite von 0,2 bis 1 mm. Die Durchbrüche 9 sind vorzugsweise 2 bis 5 mm breit und weisen einen mittleren Abstand von 2,5 bis 6 mm auf.

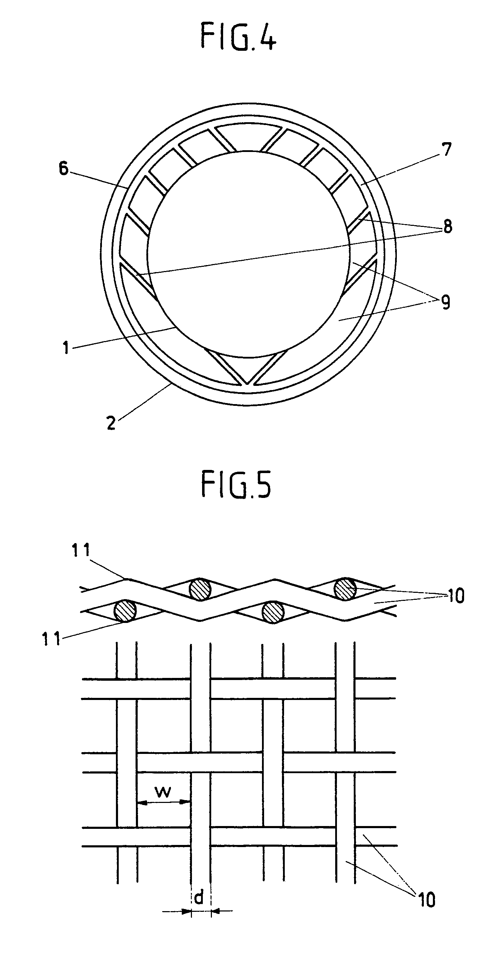

Fig. 4 zeigt einen Grundriss der Bauteile nach dem Löten unter Verwendung einer strukturierten Folie 6 gemäss Fig. 3. Die Bezugszeichen entsprechen genau denjenigen der vorangegangenen Figuren 1 und 3.

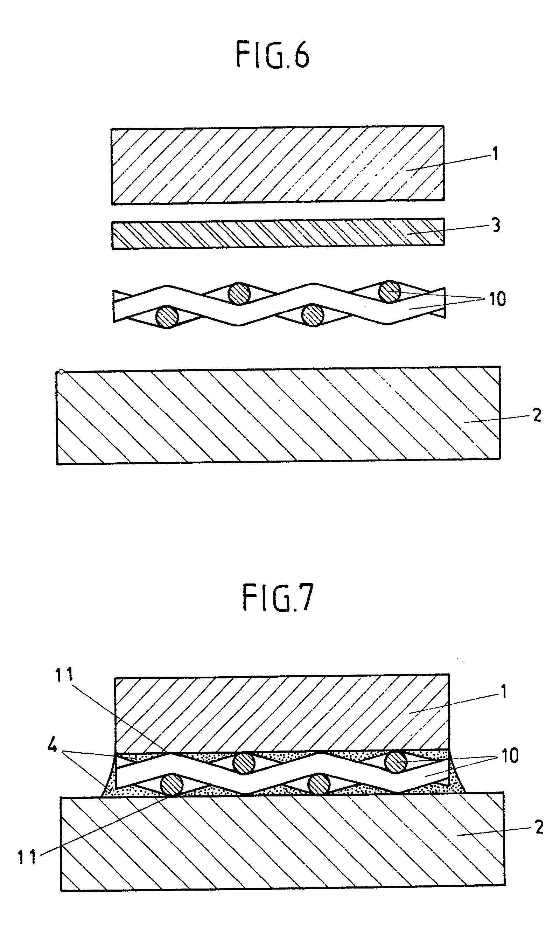

In Fig. 5 ist ein Metallgewebe 10 als Zwischenlage in Aufriss/Schnitt und Grundriss dargestellt. Die lichte Maschenweite w beträgt vorzugsweise 0,4 bis 1,0 mm, der entsprechende Drahtdurchmesser d 0,1 bis 0,2 mm. Die beim Zusammenbau und während des Lötvorgangs wirksamen, unter Druck stehenden Auflagepunkte der Drähte des Metallgewebes sind mit dem Bezugszeichen 11 versehen.

In Fig. 6 ist ein Schnitt (Aufriss) durch die zu verbindenden Bauteile vor dem Löten unter Verwendung eines Metallgewebes 10 gemäss Fig. 5 dargestellt. Die übrigen Bezugszeichen entsprechen denjenigen der Fig. 1.

Fig. 7 zeigt einen Schnitt (Aufriss) durch die verbundenen Bauteile gemäss Fig. 6 nach dem Löten unter Verwendung eines Metallgewebes 10 als Zwischenlage. Das Lot 4 füllt nach dem Löten die durch 1, 2 und 10 gebildeten Zwischenräume vollständig und porenfrei aus. Während des Lötvorgangs wird senkrecht zur Lötebene eine gewisse axiale Belastung aufgebracht, so dass die Auflagepunkte 11 der Drähte des Metallgewebes 10 gegenüber den Bauteilen 1 und 2 einen Druck ausüben.

Ausführungsbeispiel:
Vergl. Figuren 3 und 4.
Ein Halbleiter-Bauelement wurde durch Wichlöten mit einem Bauteil verbunden. Der tragende Körper des Substrats 2 bestand aus $Al_2O_3$, Typ Rubalit 705 (Fa. Rosenthal) und besasss einen kreisförmigen Querschnitt von 50 mm Durchmesser bei einer Dicke von 0,6 mm. Die beiden oberen Begrenzungsflächen wurden je mit 0,2 mm Kupfer belegt. Auf die Kupferoberfläche wurde zusätzlich eine 10μm dicke Nickelschicht (Nickelbad gemäss Fa. Shipley) stromlos abgeschieden. Eine 0,1 mm dicke strukturierte Kupferfolie 6 mit einem Aussendurchmesser des Stützringes 7 von 55 mm und einem entsprechenden Innendurchmesser von 52 mm bei einem Abstand benachbarter Stege 8 von 5 mm und einer Breite der Stege 8 von 0,2 mm wurde ebenfalls stromlos mit einer Nickelschicht von 10μm Dicke versehen. Es soll noch darauf hingewiesen werden, dass im vorliegenden Ausführungsbeispiel der Aussendurchmesser des Stützringes 7 der strukturierten Folie 6 in Abweichung zu Fig. 4 grösser war als der Durchmesser des Substrats 2, so dass die Folie 6 über das Substrat 2 vorkragte. Dies bedeutet jedoch keine Beeinträchtigung des Verfahrens, welches in dieser Hinsicht auf die Dimensionen nicht kritisch ist. Als Lot diente eine Folie von 0,1 mm Dicke und 38 mm Durchmesser mit der Zusammensetzung 95% Pb/5% Sn. Das Halbleiter-Bauelement 2 bestand aus dotiertem Si und hatte kreisförmigen Querschnitt. Seine Kontaktfläche wurde unter Vakuum zunächst mit einer 150 Å dicken Schicht von Cr durch Aufdampfen versehen. Daraufhin folgte eine 2000 Å dicke Schicht von Au, nach dem gleichen Verfahren aufgebracht. Die zu verbindenden Flächen des Halbleiter-Bauelements 1 und des Substrats 2 wurden hierauf nach dem Kathodenzerstäubungsverfahren mit je einer 5μm dicken Lotschicht (gleiche Zusammensetzung des Pb- und Sn-Gehalts wie Lotfolie) belegt.

Nun wurden die verschiedenen Bauteile in einem Lötofen in der angegebenen Reihenfolge aufeinandergelegt:
Substrat 2
Lötfolie
Strukturierte Folie 6
Halbleiter-Bauelement 1
Der ganze Stapel wurde hierauf mit einem Gewicht von 500 g belastet und auf eine Temperatur von 350°C gebracht. Die Atmosphäre war ein Gasgemisch von 15% Wasserstoff und 85% Stickstoff. Es wird noch darauf aufmerksam gemacht, dass die im vorliegenden Fall von der Fig. 1 abweichende Reihenfolge der Bauteile des Stapels nicht kritisch ist und für den Erfolg des Verfahrens keine Rolle spielt.

Die Erfindung ist nicht auf das Ausführungsbeispiel beschränkt. Die strukturierte Folie 6 kann auch andere Dimensionen aufweisen oder durch ein geeignetes Metallgewebe 10 als Zwischenlage ersetzt sein. Siehe auch Figurenbeschreibung (Fig. 1 bis 7).

Der Vorteil des Verfahrens liegt in seiner Einfachheit, Betriebssicherheit, Blasen- und Porenfreiheit der Lötstelle und gleichmässigen Geometrie sowie Stromführung des dabei erzeugten Endprodukts.

## Patentansprüche

1. Verfahren zum blasenfreien Verbinden eines grossflächigen Halbleiter-Bauelements (1) mit einem als Substrat (2) dienenden metallischen Bauteil mittels Löten, dadurch gekennzeichnet, dass der Lötspalt zwischen dem Halbleiter-Bauelement (1) und dem Substrat (2) vor, während und nach dem Lötprozess durch Anordnung einer durchbrochenen, Kanäle für den Gastransport aufweisenden metallischen Zwischenlage (5, 6, 10) genau definiert und konstant gehalten wird, und dass die zu verbindenden Teile derart aufeinandergepresst werden, dass an den jeweiligen Auflagepunkten (11) der Zwischenlage (5, 6, 10) vergleichsweise hohe Drücke erzeugt werden, so dass nach dem Löten die durch Halbleiter-Bauelement (1), Substrat (2) und Zwischenlage (5, 6, 10) gebildeten Zwischenräume vollständig und porenfrei mit dem Lot (4) ausgefüllt sind.

2. Verfahren nach Anspruch 1, dadurch gekennzeichnet, dass als Zwischenlage eine strukturierte Metallfolie (6) von 0,1 bis 0,2 mm Dicke verwendet wird, welche, in einer auf der Lötebene senkrecht stehenden Betrachtungsrichtung gesehen, V-förmig bis zu einem den Umfang begrenzenden Stützring (7) verlaufende geradlinige als Kanäle zur Entgasung der Lötspalten dienende Durchbrüche (9) von 2 bis 5 mm Breite und einem Abstand von 2,5 bis 6 mm, bei einer Breite des verbleibenden Steges (8) von 0,2 bis 1 mm aufweist, wobei die besagten Kanäle durch Stanzen oder Aetzen hergestellt werden.

3. Verfahren nach Anspruch 1, dadurch gekennzeichnet, dass als Zwischenlage ein Metallgewebe (10) mit einer lichten Maschenweite w von 0,4 bis 1,0 mm und einem Drahtdurchmesser d von 0,1 bis 0,2 mm verwendet wird.

4. Verfahren nach Anspruch 1, dadurch gekennzeichnet, dass als Werkstoff für die Zwischenlage (5, 6, 10) Cu, Ag, Au oder eine Legierung mindestens eines der vorgenannten Metalle verwendet wird.

5. Verfahren nach Anspruch 1, dadurch gekennzeichnet, dass die Zwischenlage (5, 6, 10) und/oder die zu verbindende Oberfläche des Halbleiter-Bauelements (1) und/oder des Substrats (2) vor dem Lötprozess mit einer die Benetzung fördernden metallischen Beschichtung versehen wird.

## Revendications

1. Procédé pour l'assemblage sans soufflures, par soudobrasage, d'un composant semi-conducteur (1) de grande surface avec une pièce métallique servant de substrat (2), caractérisé en ce que l'intervalle de soudobrasage entre le composant semi-conducteur (1) et le substrat (2) est défini avec précision et est maintenu constant avant, pendant et après l'opération de soudobrasage, par la mise en place d'une couche intermédiaire (5, 6, 10) métallique perforée, présentant des canaux pour le transport du gaz, et en ce que les pièces à assembler sont serrées l'une contre l'autre de façon telle qu'il se produit des pressions relativement élevées aux points d'accostage (11) de la couche intermédiaire (5, 6, 10), de telle sorte qu'après le soudobrasage les vides intermédiaires formés par le composant semi-conducteur (1), le substrat (2) et la couche intermédiaire (5, 6, 10) sont remplis entièrement et sans pores par le métal de soudobrasage (4).

2. Procédé suivant la revendication 1, caractérisé en ce qu'en guise de couche intermédiaire, on utilise une feuille métallique structurée (6) de 0,1 à 0,2 mm d'épaisseur qui, considérée suivant une direction perpendiculaire au plan de soudobrasage, présente des perforations rectilignes (9) de 2 à 5 mm de largeur et un écartement de 2,5 à 6 mm, avec un méplat restant (8) d'une largeur de 0,2 à 1 mm, qui se prolongent en forme de V jusqu'à une bague de soutien (7) limitant le périmètre et servent de canaux pour le dégazage des intervalles de soudobrasage, lesdits canaux étant réalisés par poinçonnage ou par attaque chimique.

3. Procédé suivant la revendication 1, caractérisé en ce qu'en guise de couche intermédiaire, on utilise un tissu métallique (10) avec une largeur de maille w de 0,4 à 1,0 mm et un diamètre de fil d de 0,1 à 0,2 mm.

4. Procédé suivant la revendication 1, caractérisé en ce que,.

comme matériau pour la couche intermédiaire (5, 6, 10), on utilise le cuivre, l'argent, l'or ou un alliage d'au moins un des métaux précités.

5. Procédé suivant la revendication 1, caractérisé en ce que la couche intermédiaire (5, 6, 10) et/ou la surface à assembler du composant semi-conducteur (1) et/ou du substrat (2) est pourvue, avant l'opération de soudobrasage, d'un revêtement métallique favorisant le mouillage.

## Claims

1. Method for the bubble-free joining of a large-area semiconductor component (1) by means of soldering to a metallic component part used as substrate (2), characterized in that the soldering gap between the semiconductor component (1) and the substrate (2) is accurately defined and kept constant before, during and after the soldering process by arranging a perforated metallic intermediate layer (5, 6, 10), which has ducts for moving the gas and that the parts to be joined are pressed on top of each other in such a manner that comparatively high pressures are generated at the respective support points (11) of the intermediate layer (5, 6, 10) so that, after the soldering, the intermediate spaces formed by semiconductor component (1), substrate (2) and intermediate layer (5, 6, 10) are completely filled with the solder (4) free of pores.

2. Method according to Claim 1, characterized in that a structured metal foil (6) with a thickness of 0.1 to 0.2 mm is used as intermediate layer which, seen in a direction of observation perpendicular to the soldering plane, has straight-line perforations (9), which extend in a V-shape as far as a support ring (7) delimiting the circumference, and which are used as ducts for deaerating the soldering gaps, with a width of 2 to 5 mm and a spacing of 2.5 to 6 mm, with a width of the remaining web (8) of 0.2 to 1 mm, the said ducts being produced by stamping or etching.

3. Method according to Claim 1, characterized in that a metallic fabric (10) having a clear mesh size w of 0.4 to 1.0 mm and a wire diameter d of 0.1 to 0.2 mm is used as intermediate layer.

4. Method according to Claim 1, characterized in that Cu, Ag, Au or an alloy of at least one of the aforementioned metals is used as material for the intermediate layer (5, 6, 10).

5. Method according to Claim 1, characterized in that the intermediate layer (5, 6, 10) and/or the surface, to be joined, of the semiconductor component (1) and/or of the substrate (2) is provided with a metallic coating, which promotes wetting, before the soldering process.

# FIG.1

# FIG.2

# FIG.3

## FIG.4

## FIG.5

# FIG.6

# FIG.7